# EUROPEAN PATENT APPLICATION

(11) **EP 4 651 328 A1**
(43) Date of publication of application: **19.11.2025**
(21) Application number: 23943852.6
(22) Date of filing: 06.11.2023
(51) Int. Cl.: H02H 3/18, H02H 3/00, G01R 31/55, H03K 17/78

(54) **REVERSE CONNECTION PROTECTION AND DIAGNOSIS DEVICE**

(30) Priority: 26.06.2023 KR 20230082139
(71) Applicant: LG Energy Solution, Ltd., Seoul 07335 (KR)
(72) Inventor: JEONG, Doo Ho, Daejeon 34122 (KR)
(74) Representative: Plasseraud IP
(86) International application number: PCT/KR2023/017625
(87) International publication number: WO 2025/005359

(57) **Abstract**

According to embodiments disclosed herein, a reverse-connection protecting and diagnosis device includes a power supply unit connected to a power supply device and configured to provide power, a signal transmission unit configured to change a signal transmission path in response to a connection direction of the power supply device, a protecting unit connected to an electronic device and configured to control a voltage applied to the electronic device in response to the signal transmission path, and a diagnosis unit configured to generate a diagnosis signal in response to the signal transmission path.

## Description

### [Technical Field]

### CROSS-REFERENCE TO RELATED APPLICATION

This application claims priority to and the benefit of Korean Patent Application No. 10-2023-0082139 filed in the Korean Intellectual Property Office on June 26, 2023, the entire contents of which are incorporated herein by reference.

### TECHNICAL FIELD

Embodiments disclosed herein relate to a reverse-connection protecting and diagnosis device.

### [Background Art]

Devices that form circuits are divided into forward and reverse voltages, and may operate normally at the forward voltage, but not only is it difficult to operate normally at the reverse voltage, but damage to the devices may occur.

Therefore, in general, a protecting device for preventing the reverse-connection of a power supply is provided to prevent malfunction and damage due to the reverse voltage. However, general reverse-connection protecting devices have a problem in that they only function to protect reverse connection and may not notify a reverse-connection state.

In addition, it is difficult for the general reverse-connection protecting devices to be used in high-current conduction circuits, and there is a problem in that a drop in a voltage generated from the protecting device may affect the performance of electronic devices.

### [Disclosure]

### [Technical Problem]

Embodiments disclosed herein are directed to providing a reverse-connection protecting and diagnosis device capable of protecting the reverse connection of electronic devices and at the same time, diagnosing whether the electronic devices are connected reversely.

The embodiments disclosed herein are also directed to providing a reverse-connection protecting and diagnosis device, which may be applied even in a high-current conduction circuit or a high-voltage environment and solve a problem of a voltage drop by implementing the insulation of circuits using a photo coupler.

The objects of the embodiments disclosed herein are not limited to the above-described objects, and other objects that are not mentioned will be able to be clearly understood by those skilled in the art from the following descriptions.

### [Technical Solution]

According to embodiments disclosed herein, a reverse-connection protecting and diagnosis device includes a power supply unit connected to a power supply device and configured to provide power, a signal transmission unit configured to change a signal transmission path in response to a connection direction of the power supply device, a protecting unit connected to an electronic device and configured to control a voltage applied to the electronic device in response to the signal transmission path, and a diagnosis unit configured to generate a diagnosis signal in response to the signal transmission path.

According to the embodiments, the signal transmission unit may determine the signal transmission path to be the protecting unit when the power supply device is connected normally and determine the signal transmission path to be the diagnosis unit when the power supply device is connected reversely.

According to the embodiments, the protecting unit may apply a voltage to the electronic device when receiving a signal from the signal transmission unit.

According to the embodiments, the protecting unit may include a switch of which on/off is controlled by receiving a voltage, and a Zener diode connected in parallel with the switch.

According to the embodiments, the switch may be turned on when receiving the signal from the signal transmission unit so that the voltage is applied to the electronic device.

According to the embodiments, the diagnosis unit may include a controller, and the controller may generate the diagnosis signal based on the signal transmission from the signal transmission unit.

According to the embodiments, the diagnosis unit may include a detection element, and the detection element may be turned on when receiving a signal from the signal transmission unit.

According to the embodiments, the signal transmission unit may include a light emitting unit connected to the power supply unit, and a light receiving unit connected to the protecting unit and the diagnosis unit and may be set so that, when the light emitting unit is turned on, the light receiving unit is turned on to transmit the signal.

According to the embodiments, the light emitting unit may include a first light emitting element and a second light emitting element which is connected to the power supply unit in opposite direction and of which on/off is controlled based on a connection direction of the power supply device, the light receiving unit may include a first light receiving element connected to the protecting unit and a second light receiving element connected to the diagnosis unit, the first light receiving element may correspond to the first light emitting element, and the second light receiving element may correspond to the second light emitting element.

According to the embodiments, the second light emitting element may be connected in a direction opposite the normal connection direction of the power supply device.

According to embodiments disclosed herein, a reverse-connection protecting and diagnosis device includes a power supply circuit connected to a first terminal, a second terminal, and an input terminal of a photo coupler and connected to a power supply device connected to the first terminal and the second terminal, a protecting circuit including a switch connected to an output terminal of the photo coupler and connected to an electronic device, and a diagnosis circuit including at least one of a controller connected to the output terminal of the photo coupler and a detecting element, the photo coupler includes a light emitting circuit connected to the power supply circuit through the input terminal, and a light receiving circuit connected to the protecting circuit and the diagnosis circuit through the output terminal, and the light receiving circuit receives a light emitting signal of the light emitting circuit.

According to the embodiments, the light emitting circuit may include a first light emitting element and a second light emitting element connected to the power supply circuit in opposite directions, the light receiving circuit may include a first light receiving element connected to the protecting unit and a second light receiving element connected to the diagnosis unit, the first light receiving element may correspond to the first light emitting element, and the second light receiving element corresponds to the second light emitting element, and the second light emitting element may be connected in a direction opposite the normal connection direction of the power supply device.

According to the embodiments, the protecting circuit may include the switch and the Zener diode connected to any one of a positive electrode terminal and a negative electrode terminal and the output terminal of the photo coupler, and the switch and the Zener diode may be connected in parallel.

According to the embodiments, the diagnosis circuit may include a second power supply, the controller, and a detection element, and the detection element may be connected to the output terminal of the photo coupler and the second power supply.

### [Advantageous Effects]

The protecting and diagnosis device according to the embodiments disclosed herein can protect the reverse voltage applied to the electronic device and at the same time, diagnose whether the power supply device is connected reversely.

In addition, the protecting and diagnosis device according to the embodiments disclosed herein can be used in the high-current conduction circuit or the environment in which the voltage at the input terminal is the high voltage by transmitting the signals through the photo coupler.

In addition, various effects that may be directly or indirectly identified through this document can be provided.

### [Description of Drawings]

FIG. 1 is a view illustrating a configuration of a reverse-connection protecting and diagnosis device according to one embodiment disclosed herein.
FIG. 2 is a view illustrating an example of a circuit diagram of the reverse-connection protecting and diagnosis device according to one embodiment disclosed herein.
FIG. 3 is a view illustrating an example when a power supply device is connected normally in the reverse-connection protecting and diagnosis device according to one embodiment disclosed herein.
FIG. 4 is a view illustrating an example when the power supply device is connected reversely in the reverse-connection protecting and diagnosis device according to one embodiment disclosed herein.

### [Mode for Invention]

Hereinafter, various embodiments of the present invention will be described with reference to the accompanying drawings. However, it should be understood that this is not intended to limit the present invention to specific embodiments and includes various modifications, equivalents, and/or alternatives of the embodiments of the present invention.

The singular form of a noun corresponding to an item in this document may include one item or a plurality of items unless the relevant context clearly dictates otherwise. In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," or "second" may simply be used to distinguish the corresponding component from another and do not limit the corresponding components in another aspect (e.g., importance or order). In this document, when a certain (e.g., a first) component is described as being "connected," "coupled," or "joined or "coupled" or "connected" to another (e.g., a second) component with or without the terms "functionally" or "communicatively," this means that the certain component may be connected to another component directly (e.g., by wire), wirelessly, or through a third component.

Each (e.g., a module or a program) of components described herein may include a single object or a plurality of objects. According to various embodiments, one or more among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to various embodiments, operations performed by modules, programs, or other components may be executed sequentially, in parallel, repeatedly, or heuristically, or one or more of the operations may be executed in a different order or omitted, or one or more other operations may be added.

As used herein, the term "module," or "part" may include a unit implemented in hardware, software, or firmware and may be used interchangeably with terms such as logic, logic block, component, or circuit. The module may be an integrated part or a minimum unit of the parts or a portion thereof that performs one or more functions. For example, according to one embodiment, the module may be implemented in the form of an application-specific integrated circuit (ASIC).

Various embodiments of this document may be implemented as software (e.g., a program or application) including one or more commands stored in a storage medium (e.g., a memory) that may be read by a machine. For example, a processor of the device may fetch at least one command among one or more commands stored from a storage medium and execute the commands. This allows the device to be operated to perform at least one function according to the at least one fetched command. The one or more commands may include code generated by a compiler or code that may be executed by an interpreter. A device-readable storage medium may be provided in the form of a non-transitory storage medium. Here, "non-transitory storage medium" is a tangible device and only means not including a signal (e.g., electromagnetic waves), and this term does not distinguish between cases in which data is stored semi-permanently and temporarily in the storage medium.

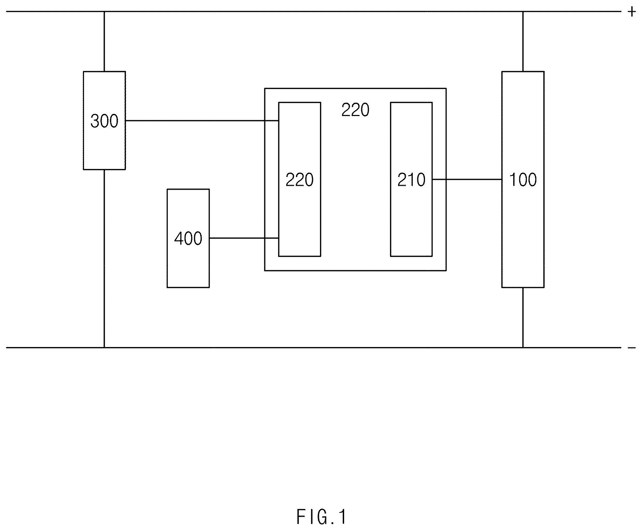

FIG. 1 is a view illustrating a configuration of a reverse-connection protecting and diagnosis device according to one embodiment disclosed herein.

Referring to FIG. 1, the reverse-connection protecting and diagnosis device may include a power supply unit 100, a signal transmission unit 200, a protection unit 300, and a diagnosis unit 400.

The reverse-connection protecting and diagnosis device can prevent a reverse voltage applied to an electronic device due to reverse-connection of a power supply device and simultaneously diagnose whether the power supply device is connected reversely.

The power supply unit 100 may be connected to the power supply device to provide power. The power supply device may be connected between a positive electrode terminal and a negative electrode terminal connected to the power supply unit 100. The power supply device may be connected to the power supply unit 100 to provide power (voltage) between the positive electrode terminal and the negative electrode terminal. The power supply device may include various devices capable of supplying power, such as dry cells, secondary batteries, batteries, and storage batteries.

The power supply unit 100 may transmit power provided from the power supply device to components connected to the power supply unit 100. For example, the power supply unit 100 may be connected to an input terminal of the signal transmission unit 200, and when the power supply device is connected to the power supply unit 100, the power supply unit 100 may provide power to the signal transmission unit 200.

The signal transmission unit 200 may transmit an input signal of the power supply unit 100 as an output signal. The signal transmission unit 200 may receive an electrical signal (e.g., a current) from the power supply unit 100 and transmit an output signal corresponding to the input electrical signal through an output terminal. For example, the output terminal of the signal transmission unit 200 may be connected to the protecting unit 300 and the diagnosis unit 400, and the signal transmission unit 200 may transmit the output signal to at least any one of the protecting unit 300 and the diagnosis unit 400.

The signal transmission unit 200 may transmit the output signal to at least any one of the protecting unit 300 and the diagnosis unit 400 so that driving of the protecting unit 300 and the diagnosis unit 400 may be controlled. For example, the signal transmission unit 200 may output an output current (corresponding to the output signal) corresponding to a current (corresponding to the input signal) input to the input terminal to the output terminal.

The signal transmission unit 200 may change a signal transmission path in response to a connection direction of the power supply device. In an embodiment, the signal transmission unit 200 may change the signal transmission path to any one of the protecting unit 300 and the diagnosis unit 400 in response to the connection direction of the power supply device. For example, when the power supply device is connected normally, the signal transmission unit 200 may determine the signal transmission path to the protecting unit 300. In other words, the signal transmission unit 200 may transmit the output signal to the protecting unit 300 when the power supply device is in the normal connection direction. Conversely, when the power supply device is connected reversely, the signal transmission unit 200 may determine the signal transmission path to the diagnosis unit 400.

The signal transmission unit 200 may include a photo coupler. The photo coupler is a circuit element for coupling electrical signals into light and may be an element for transmitting electrical signals at an input terminal to an output terminal as optical signals. In addition, the photo coupler may be a circuit element capable of transmitting electrical signals using light in a state in which circuits at the input terminal and the output terminal are insulated electrically. It goes without saying that the signal transmission unit 200 can be implemented as various elements that enable selective connection/disconnection of circuits in addition to the photo coupler.

When the signal transmission unit 200 includes the photo coupler, there is an advantage in that the circuits at the input terminal and the output terminal are insulated, and thus can be applied even in an environment in which an input voltage is higher than a rated voltage of an electronic device, and the signal transmission unit 200 can also be applied in a high-current conduction circuit and can reduce the voltage drop effect that may be caused when a circuit element (e.g., a transistor) connected electrically is used. Hereinafter, for convenience of understanding and description, the signal transmission unit 200 will be described as the photo coupler.

According to an embodiment, the photo coupler 200 may include a light emitting unit 210 and a light receiving unit 220. The light emitting unit 210 may be connected to the power supply unit 100, and the light receiving unit 220 may be connected to the protecting unit 300 and the diagnosis unit 400. For example, the light emitting unit 210 may be configured at an input terminal of the photo coupler 200, and the light receiving unit 220 may be configured at an output terminal of the photo coupler 200.

The photo coupler 200 may be set so that the light receiving unit 220 is turned on to transmit a signal when the light emitting unit 210 is turned on. When the photo coupler 200 receives an input signal from the power supply unit 100 at the input terminal, the light emitting unit 210 may be turned on. At this time, the light receiving unit 220 may receive light emitted from the light emitting unit 210 and be turned on. The light receiving unit 220 may receive light and be turned on so that an output signal may be transmitted to the output terminal. For example, the light emitting unit 210 may be turned on to emit light when power is applied to the photo coupler 200 by the power supply unit 100 and a current flows, and in this case, the light receiving unit 220 may receive the light and be turned on so that an output current corresponding to the input current may flow through the output terminal of the photo coupler 200.

According to an embodiment, the light emitting unit 210 may include a first light emitting element and a second light emitting element connected to the power supply unit 200 in opposite directions. In addition, the light receiving unit 220 may include a first light receiving element connected to the protecting unit 300 and a second light receiving element connected to the diagnosis unit 400. In this case, the first light receiving element may correspond to the first light emitting element, and the second light receiving element may correspond to the second light emitting element. Here, when the first light receiving element corresponds to the first light emitting element, it may mean that light emitted from the first light emitting element may be received by the first light receiving element. Likewise, light emitted from the second light emitting element may be received by the second light receiving element.

In an embodiment, the first light emitting element and the second light emitting element may be controlled to be turned on and off based on the connection direction of the power supply device. For example, any one of the first light emitting element and the second light emitting element may be turned on depending on the connection direction of the power supply device. For example, the first light emitting element may be turned on when the power supply device is connected normally, and the second light emitting element may be turned on when the power supply device is connected reversely. The first light emitting element and the second light emitting element may be photodiodes through which a current may flow in only one direction.

In an embodiment, the second light emitting element may be connected in a direction opposite to the normal connection direction of the power supply device. Here, the normal connection direction of the power supply device may be a direction in which a forward voltage is applied between the positive electrode terminal and the negative electrode terminal (i.e., a direction in which a (+) terminal of the power supply device is connected to the positive electrode terminal and a (-) terminal of the power supply device is connected to the negative electrode terminal). In addition, when the second light emitting element is connected in a direction opposite to the normal connection direction of the power supply device, it may mean that the second light emitting element is connected so that a current flows when the power supply device is connected reversely. For example, when the second light emitting element is a photodiode, the second light emitting element may be connected so that an anode faces the negative electrode terminal and a cathode faces the positive electrode terminal.

The photo coupler 200 may be a dual-channel photo coupler and may be configured as two single-channel photo couplers. When the photo coupler 200 is the dual-channel photo coupler, the first light emitting element, the second light emitting element, the first light receiving element, and the second light receiving element may be provided in one photo coupler, the first light emitting element and the first light receiving element may form a first channel, and the second light emitting element and the second light receiving element may form a second channel. When the photo coupler 200 is configured as two single-channel photo couplers, the photo coupler 200 may include a first photo coupler and a second photo coupler that are separated physically. In this case, the first light emitting element and the first light receiving element may form the first photo coupler, and the second light emitting element and the second light receiving element may form the second photo coupler. The number of channels and the number of single channel photo couplers provided in the photo coupler 200 are not limited thereto.

The protecting unit 300 may be connected to an electronic device. The electronic device may be connected between the positive electrode terminal and the negative electrode terminal connected to the protecting unit 300. The positive electrode terminal and the negative electrode terminal connected to the protecting unit 300 may be the same as or different from the positive electrode terminal and the negative electrode terminal connected to the power supply unit 100, respectively. In addition, a reference potential between the positive electrode terminal and the negative electrode terminal connected to the protecting unit 300 may be the same as or different from a reference potential between the positive electrode terminal and the negative electrode terminal connected to the power supply unit 100.

The protecting unit 300 may control a voltage applied to the electronic device in response to a signal transmission path. For example, the protecting unit 300 may apply or block the voltage to the electronic device according to the signal transmission path. For example, when the signal transmission path by the photo coupler 200 is determined to be the protecting unit 300, the protecting unit 300 may apply the voltage to the electronic device. The protecting unit 300 may control a magnitude of the voltage applied to the electronic device according to the output signal corresponding to the input signal. Conversely, when the signal transmission path by the photo coupler 200 is determined to be the diagnosis unit 400, the protecting unit 300 may block the voltage to the electronic device.

According to an embodiment, the protecting unit 200 may include a switch of which on/off control is controlled by receiving a voltage and a Zener diode for applying the voltage to the switch.

The switch may be controlled to be turned on and off by receiving the voltage. The switch may form a closed circuit in relation to the electronic device depending on whether it is turned on or off. For example, when the switch is turned on, the protecting unit 200 may form a closed circuit with the electronic device so that the voltage may be applied to the electronic device. Conversely, when the switch is turned off, the protecting unit 200 and the electronic device may be disconnected to block the voltage to the electronic device.

The Zener diode may be connected in parallel with the switch to provide the voltage to the switch. The Zener diode may provide a constant voltage to the switch. The Zener diode is a type of diode and may be a circuit element for providing a constant voltage using the Zener effect. The Zener effect refers to a phenomenon in which a reverse current increases rapidly when a reverse voltage higher than a breakdown voltage is applied to a diode, and by using this, a constant voltage can be maintained despite a rapid change in current. To this end, the breakdown voltage of the Zener diode may be set to be lower than that of a general diode. The Zener diode may be connected in a reverse direction with respect to the output terminal of the photo coupler 200 and for example, may be connected so that the anode faces the negative electrode terminal and the cathode faces the positive electrode terminal.

The diagnosis unit 400 may generate a diagnosis signal in response to the signal transmission path. For example, when the signal transmission path of the photo coupler 200 is determined to be the diagnosis unit 400, the diagnosis unit 400 may receive an output signal from the photo coupler 200 and generate the diagnosis signal.

The diagnosis unit 400 may include a controller for generating the diagnosis signal. The controller may generate the diagnosis signal based on the signal transmission from the photo coupler 200. The diagnosis signal may include a digital signal, a voice signal, an optical signal, or the like. For example, when the signal transmission path of the signal transmission unit 200 is the diagnosis unit 400, a current may flow through the diagnosis unit 400, and the controller may detect the current and generate the diagnosis signal. For example, the controller may generate a digital signal of 1 when the current is detected and generate a digital signal of 0 when no current is detected. In this case, when the digital signal is 1, the controller may determine that the power supply has been connected reversely, and when the digital signal is 0, the controller may determine that the power supply has been connected normally. In addition, the user of the reverse-connection protecting and diagnosis device may check whether the power supply device is connected reversely according to the signals of the controller, and in some cases, the controller may provide additional alarms according to the diagnosis signal.

According to an embodiment, the diagnosis unit 400 may include a detection element. The detection element may be turned on when receiving a signal from the photo coupler 200. The detection element may be turned on by a current flowing when the diagnosis unit 400 receives the signal from the photo coupler 200. The detection element may include an optical element such as a diode, an audio element for emitting sound, or the like. For example, when the detection element is a light emitting diode (LED) element, the LED may be turned on to express an optical signal.

As described above, the diagnosis unit 400 may diagnose the reverse connection of the power supply device through the digital signal, the optical signal, the voice signal, or the like.

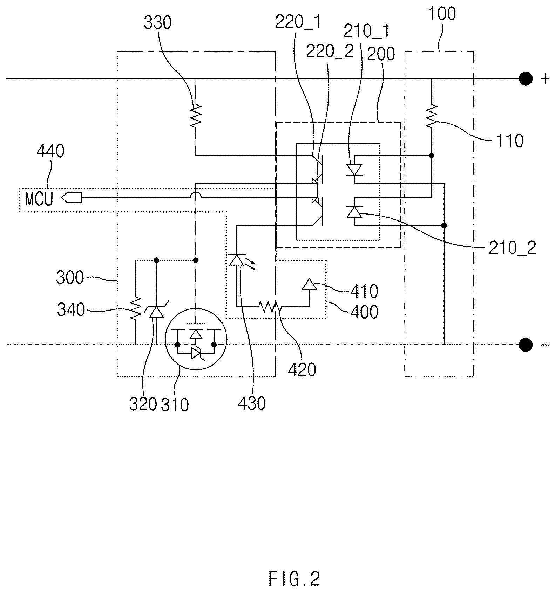

FIG. 2 is a view illustrating an example of a circuit diagram of the reverse-connection protecting and diagnosis device according to one embodiment disclosed herein.

Referring to FIG. 2, the reverse-connection protecting and diagnosis device may diagnose whether the power supply device is connected reversely and can prevent the reverse voltage from being applied to the electronic device.

The power supply unit 100 may be configured as a power supply circuit. The power supply circuit may be connected to the first terminal (positive electrode terminal), the second terminal (negative electrode terminal), and the input terminal of the photo coupler 200. In this case, the power supply device may be connected between the first terminal and the second terminal to provide power. The power supply circuit may include a first resistor 110 for adjusting the current flowing through the photo coupler 200. The first resistor 110 may be connected between any one of the first terminal and the second terminal and the input terminal of the photo coupler 200.

The photo coupler 200 may have the input terminal connected to the power supply circuit and the output terminal connected to a protecting circuit and a diagnosis circuit. The photo coupler 200 may change the signal transmission path in response to the connection direction of the power supply device.

The photo coupler 200 may include a light emitting circuit connected to the power supply circuit through the input terminal and the light receiving circuit connected to the protecting circuit and the diagnosis circuit through the output terminal. The light emitting circuit and the light receiving circuit may be insulated electrically. The light receiving circuit may receive a light emitting signal from the light emitting circuit. In other words, the photo coupler 200 may transmit the input signal applied from the power supply circuit to the output terminal as an optical signal.

When the light emitting circuit receives the input signal from the power supply circuit, the light emitting element 210 included in the light emitting circuit may be turned on. The light receiving circuit may receive light emitted from the light emitting circuit. When the light receiving circuit receives light, the output signal may be transmitted through the light receiving circuit.

The light emitting circuit may include a first light emitting element 211 and a second light emitting element 213. In an embodiment, the first light emitting element 211 and the second light emitting element 213 may be connected to the power supply unit in opposite directions. For example, the first light emitting element 211 and the second light emitting element 213 may be photodiodes, and the first light emitting element 211 may be connected so that the anode faces the first terminal and the cathode faces the second terminal. Conversely, the second light emitting element 213 may be connected so that the anode faces the second terminal and the cathode faces the first terminal. The first light emitting element 211 and the second light emitting element 213 may be connected in parallel.

According to an embodiment, the second light emitting element 223 may be connected in a direction opposite to the normal connection direction of the power supply device. In other words, the second light emitting element 223 may be connected to be turned on when the power supply device is connected reversely.

The light receiving circuit may include a first light receiving element 221 connected to the protecting circuit and a second light receiving element 223 connected to the diagnosis circuit. In an embodiment, the first light receiving element 221 may correspond to the first light emitting element 211, and the second light receiving element 223 may correspond to the second light emitting element 213. In other words, the first light receiving element 221 may receive light emitted from the first light emitting element 211, and the second light receiving element 223 may receive light emitted from the second light emitting element 213.

The first light receiving element 221 and the second light receiving element 223 may be transistors. For example, the first light receiving element 221 and the second light receiving element 223 may be photo transistors configured to receive light at a base. When the first light receiving element 221 and the second light receiving element 223 each receive light through the base, a current may flow from a collector to an emitter when the first light receiving element 221 and the second light receiving element 223 are npn transistors, and a current may flow from the emitter to the collector when the first light receiving element 221 and the second light receiving element 223 are pnp transistors. In other words, when the first light receiving element 221 and the second light receiving element 223 receive light, the current may flow.

As described above, the signal transmission path of the photo coupler 200 may be changed depending on the connection direction of the power supply device. For example, when the power supply device is connected normally, the first light emitting element 211 is turned on and the first light receiving element 221 receives light so that a current may flow through the protecting circuit, and when the power supply device is connected reversely, the second light element 213 is turned on and the second light receiving element 223 receives light so that a current flows through the diagnosis circuit.

The input terminal of the photo coupler 200 may include a first input terminal and a second input terminal, and the output terminal may include a first output terminal and a second output terminal. The first input terminal may be connected to the first light emitting element 211, and the second input terminal may be connected to the second light emitting element 213. Likewise, the first output terminal may be connected to the first light receiving element 221, and the second output terminal may be connected to the second light receiving element 223.

The protecting unit 300 may be configured as the protecting circuit. The protecting circuit may include a switch 310 connected to the output terminal of the photo coupler 200, and an electronic device may be connected to the switch 310. The protecting circuit may be connected to a third terminal (positive electrode terminal) and a fourth terminal (negative electrode terminal) to which the electronic device is connected, and the electronic device may be connected to the third terminal and the fourth terminal.

The protecting circuit may be connected to the first light receiving element 221 through the first output terminal of the photo coupler 200. In this case, when the first light receiving element 221 receives light, the first light receiving element 221 may be connected to the protecting circuit so that a forward current (flowing from the third terminal to the fourth terminal) flows. For example, when the first light receiving element 221 is an npn transistor, the first light receiving element 221 may be connected so that the collector faces the third terminal and the emitter faces the fourth terminal. Conversely, when the second light emitting element 221 is a pnp transistor, the second light emitting element 221 may be connected so that the emitter faces the third terminal and the collector faces the fourth terminal.

The protecting circuit may include a switch 310 and a Zener diode 320 connected to any one of the third terminal and the fourth terminal and the first output terminal.

The switch 310 may be controlled to allow a voltage to be applied to the electronic device depending on whether it is turned on or off. The switch 310 may be turned on when receiving the voltage and turned off when not receiving the voltage. For example, when the power supply device is connected normally and the first light receiving element 221 receives light, a current may flow through the protecting circuit and a voltage may be applied to the switch 310 so that the voltage may be applied to the electronic device. Conversely, when the power supply device is connected reversely, the first light receiving element 221 may not receive light and thus a current does not flow through the protecting circuit, and the switch 310 may be turned off to prevent the voltage from being applied to the electronic device.

In an embodiment, the switch 310 may be a field effect transistor (FET) switch. When the switch 310 is connected to the third terminal (positive electrode terminal), the switch 310 may be a PMOSFET, and when the switch 310 is connected to the fourth terminal (negative electrode terminal), the switch 310 may be an NMOSFET.

The Zener diode 320 may be connected in parallel with the switch 310 to provide a voltage to the switch 310. The Zener diode 320 may provide a constant voltage to the switch 310. For example, the Zener diode 320 may be connected so that the anode faces the negative electrode terminal and the cathode faces the positive electrode terminal to provide the constant voltage to the switch 310 by receiving a reverse voltage.

The protecting circuit may include a second resistor 330 connected in parallel with the switch 310 and the Zener diode 320, and a third resistor 340 connected to a terminal opposite to the terminal to which the first output terminal and the switch 310 are connected. When the first light receiving element 221 receives light and the current flows through the protecting circuit, the current flows through the second resistor 330 and a breakdown voltage may be applied to the Zener diode 320. The third resistor 340 may adjust the current flowing through the protecting circuit.

The diagnosis unit 400 may be configured as the diagnosis circuit. The diagnosis circuit may be connected to the second output terminal of the photo coupler 200. The diagnosis circuit may include a second power source 410 for providing a reference terminal voltage. Since the diagnosis circuit is not connected to the first terminal to the fourth terminal, the second power source 410 for providing the reference terminal voltage may be required. The diagnosis circuit may include a fourth resistor 420 for adjusting a current. The fourth resistor 420 may be connected to the second power source 410.

The diagnosis circuit may include at least one of a controller 440 and a detection element 430 connected to the output terminal of the photo coupler 200.

The detection element 430 may be connected to the second output terminal of the photo coupler 200 and the fourth resistor 420. When the detection element 430 receives a signal from the photo coupler 200, the detection element 430 may be turned on. The detection element 430 may be, for example, an LED, a sound element, or the like.

The controller 440 may be connected to the second output terminal of the photo coupler 200. The controller 440 may receive the signal received from the photo coupler 200 and generate the diagnosis signal. For example, the controller 440 may generate a digital signal depending on whether a current is detected through the diagnosis circuit. The controller 440 may be an information processing device such as a micro control unit (MCU) or a CPU.

The diagnosis circuit may diagnose whether the power supply device is connected reversely according to the on/off of the detection element 430 and/or the diagnosis signal generated from the controller 440.

The first resistor to the fourth resistor may be current limiting resistors. The current limiting resistor may be used in various terms, such as a pull-down resistor and may be a resistor for adjusting a current flowing in a circuit connected to the resistor.

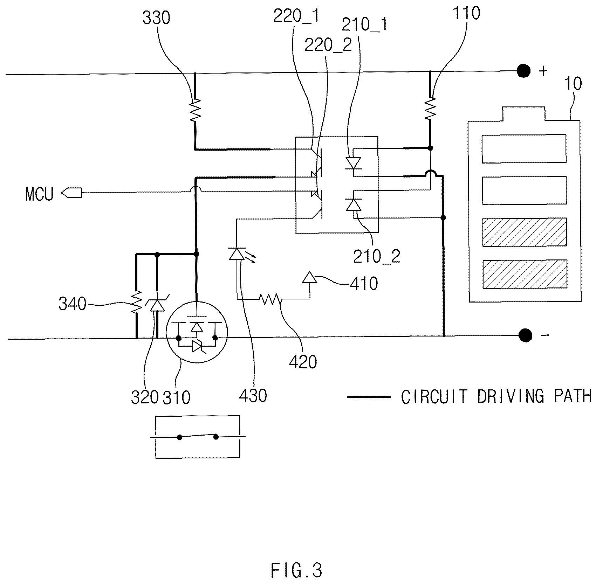

FIG. 3 is a view illustrating an example when a power supply device is connected normally in the reverse-connection protecting and diagnosis device according to one embodiment disclosed herein. Referring to FIG. 3, the circuit that is driven when the power supply device is connected normally is marked by a bold line.

Since a forward current flows through the first light emitting element 211 when the power supply device is connected normally, the first light emitting element 211 may be turned on. Conversely, since only a reverse current larger than or equal to a threshold flows through the second light emitting element 213, the second light emitting element 213 may be turned off.

The first light receiving element 221 may receive light from the first light emitting element 211 so that a forward current may flow through the protecting circuit. At this time, a reverse voltage is applied to the Zener diode 320, and a constant voltage is applied to the switch 310 by the Zener diode 320 so that the switch 310 may be turned on. Therefore, the electronic device and the protecting circuit form a closed circuit so that a forward voltage may be applied to the electronic device.

Since the second light receiving element 223 does not receive light due to the turn-off of the second light emitting element 213, a current may not flow through the diagnosis circuit. Therefore, the detection element 430 is turned off, and the controller 440 may generate a diagnosis signal indicating that no current is detected.

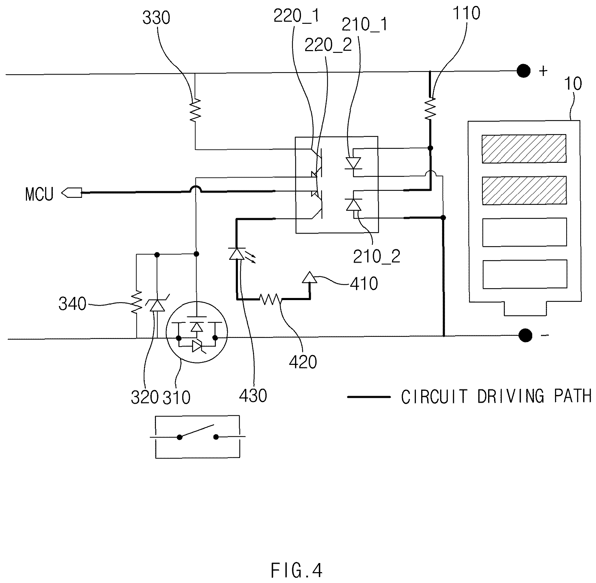

FIG. 4 is a view illustrating an example when the power supply device is connected reversely in the reverse-connection protecting and diagnosis device according to one embodiment disclosed herein. Referring to FIG. 4, the circuit that is driven when the power supply device is connected reversely is marked by a bold line.

Since a forward current flows through the second light emitting element 213 when the power supply device is connected reversely, the second light emitting element 213 may be turned on. Conversely, since only a reverse current smaller than or equal to a threshold flows through the first light emitting element 211, the first light emitting element 211 may be turned off.

Since the first light receiving element 221 does not receive light due to the turn-off of the first light emitting element 211, a current may not flow through the protecting circuit. Therefore, a voltage is not applied to the switch 310, and the switch 310 may be turned off to block the application of the voltage to the electronic device.

The second light receiving element 223 may receive light from the second light emitting element 213 so that a current may flow through the diagnosis circuit. Therefore, the detection element 430 is turned on, and the controller 440 may generate a diagnosis signal indicating that a current is detected. Therefore, the user of the electronic device can confirm that the power supply device has been connected reversely from a state of the detection element 430 and the diagnosis signal of the controller 440.

As described above, although all the components constituting the embodiments disclosed herein were described as being coupled or operated by being coupled, the embodiments disclosed herein are not necessarily limited to these embodiments. In other words, one or more of all the components may be operated by being selectively coupled without departing from the scope of the purpose of the embodiments disclosed herein.

In addition, the terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed in this document, and those skilled in the art to which embodiments disclosed in this document pertain will be able to variously modify and change the present disclosure without departing from the essential characteristics of the embodiments disclosed in this document. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A reverse-connection protecting and diagnosis device comprising:
a power supply unit connected to a power supply device and configured to provide power;
a signal transmission unit configured to change a signal transmission path in response to a connection direction of the power supply device;
a protecting unit connected to an electronic device and configured to control a voltage applied to the electronic device in response to the signal transmission path; and
a diagnosis unit configured to generate a diagnosis signal in response to the signal transmission path.

2. The reverse-connection protecting and diagnosis device according to claim 1, wherein the signal transmission unit is configured to:
determine the signal transmission path to be the protecting unit when the power supply device is connected normally; and
determine the signal transmission path to be the diagnosis unit when the power supply device is connected reversely.

3. The reverse-connection protecting and diagnosis device according to claim 2, wherein the protecting unit applies a voltage to the electronic device when receiving a signal from the signal transmission unit.

4. The reverse-connection protecting and diagnosis device according to claim 3, wherein the protecting unit includes:
a switch of which on/off is controlled by receiving a voltage; and
a Zener diode connected in parallel with the switch.

5. The reverse-connection protecting and diagnosis device according to claim 4, wherein the switch is turned on when receiving the signal from the signal transmission unit so that the voltage is applied to the electronic device.

6. The reverse-connection protecting and diagnosis device according to claim 2, wherein the diagnosis unit includes a controller, and
the controller generates the diagnosis signal based on the signal transmission from the signal transmission unit.

7. The reverse-connection protecting and diagnosis device according to claim 2, wherein the diagnosis unit includes a detection element, and
the detection element is turned on when receiving a signal from the signal transmission unit.

8. The reverse-connection protecting and diagnosis device according to claim 1, wherein the signal transmission unit includes:
a light emitting unit connected to the power supply unit; and
a light receiving unit connected to the protecting unit and the diagnosis unit, and
is set so that, when the light emitting unit is turned on, the light receiving unit is turned on to transmit the signal.

9. The reverse-connection protecting and diagnosis device according to claim 8, wherein the light emitting unit includes a first light emitting element and a second light emitting element which is connected to the power supply unit in opposite direction and of which on/off is controlled based on a connection direction of the power supply device,
the light receiving unit includes a first light receiving element connected to the protecting unit and a second light receiving element connected to the diagnosis unit, and
the first light receiving element corresponds to the first light emitting element, and the second light receiving element corresponds to the second light emitting element.

10. The reverse-connection protecting and diagnosis device according to claim 9, wherein the second light emitting element is connected in a direction opposite the normal connection direction of the power supply device.

11. A reverse-connection protecting and diagnosis device comprising:
a power supply circuit connected to a first terminal, a second terminal, and an input terminal of a photo coupler and connected to a power supply device connected to the first terminal and the second terminal;
a protecting circuit including a switch connected to an output terminal of the photo coupler and connected to an electronic device; and
a diagnosis circuit including at least one of a controller connected to the output terminal of the photo coupler and a detecting element,
the photo coupler includes:
a light emitting circuit connected to the power supply circuit through the input terminal; and
a light receiving circuit connected to the protecting circuit and the diagnosis circuit through the output terminal, and
the light receiving circuit receives a light emitting signal of the light emitting circuit.

12. The reverse-connection protecting and diagnosis device according to claim 11, wherein the light emitting circuit includes a first light emitting element and a second light emitting element connected to the power supply circuit in opposite directions,
the light receiving circuit includes a first light receiving element connected to the protecting unit and a second light receiving element connected to the diagnosis unit,
the first light receiving element corresponds to the first light emitting element, and the second light receiving element corresponds to the second light emitting element, and
the second light emitting element is connected in a direction opposite the normal connection direction of the power supply device.

13. The reverse-connection protecting and diagnosis device according to claim 11, wherein the protecting circuit includes the switch and the Zener diode connected to any one of a positive electrode terminal and a negative electrode terminal and the output terminal of the photo coupler, and
the switch and the Zener diode are connected in parallel.

14. The reverse-connection protecting and diagnosis device according to claim 11, wherein the diagnosis circuit includes:
a second power supply;
the controller; and
a detection element, and
the detection element is connected to the output terminal of the photo coupler and the second power supply.
